# EUROPEAN PATENT SPECIFICATION

(11) **EP 0 425 737 B1**
(45) Date of publication and mention of the grant of the patent: **01.12.1993**
(21) Application number: 89311173.2
(22) Date of filing: 30.10.1989
(51) Int. Cl.: G01R 13/34, G01R 13/24

(54) **Digital storage oscilloscopes**
Digitale Speicheroszilloskope
Oscilloscope à enregistrement numérique

(43) Date of publication of application: 08.05.1991
(73) Proprietor: TEKTRONIX UK LTD., Marlow, Bucks SL7 1YD (GB)
(72) Inventor: Stanyon, John Michael, Hoddesdon, Herts., (GB); Clutterbuck, Keith Louis, Hertford Heath, Herts, SG13 7QJ (GB)
(74) Representative: Burke, Steven David

(56) References cited:
- EP-A- 0 244 052
- US-A- 4 225 940
- FIRMENDRUCKSCHRIFT TEKTRONIX TEK 2230/2220, 1985, "Portable Digitalspeicher-Oszilloskope mit bestechenden Features"
- WIRELESS WORLD, vol. 86, no. 1535, 1980, pages 69-73, Haywards Health, GB; G.J. Adams: "Transient Recorder - Digital Instrument stores analogue waveforms"

## Description

This invention relates to digital storage oscilloscopes, and is particularly but not exclusively concerned with dual mode oscilloscopes which may operate selectively either in a digital storage mode or an analog mode.

Conventional analog oscilloscopes have a timebase setting switch which permits the sweep rate, i.e. the rate at which an electron beam horizontally traverses a display screen, to be varied in discrete steps, so that a user can adjust the setting in order to cause approximately a selected duration of the input waveform to be shown on the screen. Such oscilloscopes also incorporate a continuous-adjustment control, which gives the user continuous adjustment of the sweep rate between the discrete settings. The user can therefore continuously adjust the duration of the signal portion selected for display on the screen, and can align selected points on the waveform with a graticule of the display. Often, the continuous-adjustment control is a potentiometer which has an end setting at which the sweep rate is calibrated, so that if the user needs to know the exact duration between two points on the waveform he can move the potentiometer to the calibration setting and calculate the duration from the distance between the two points as displayed on the screen.

Another well known form of oscilloscope is the digital storage oscilloscope, in which the input waveform is digitised, stored in a memory, and then read out of the memory and displayed on a screen. Such oscilloscopes have the advantage that they can provide a very high degree of accuracy, by the use of fixed-frequency crystal oscillators for controlling the rate at which the input waveform samples are loaded into the memory and the rate at which they are read out and displayed on the screen. Such oscilloscopes also have other advantages, including the ability to store transient waveforms which can then be displayed for any selected period, and the ability to manipulate the stored data in a number of ways. One known feature provided on some storage oscilloscopes is a "pre-trigger" waveform display. In the "pre-trigger" mode, the acquisition of data samples is so controlled that the display shows a portion of the input waveform preceding a selected trigger point, normally in addition to a portion which follows the trigger point. This is a very useful feature which cannot be provided by conventional analog oscilloscopes except by using an expensive delay line which would have a limited range.

It is also known to provide a dual mode oscilloscope, which can operate selectively either in an analog mode or a digital storage mode. Normally, in such dual mode oscilloscopes, the continuous-adjustment control operates only when the oscilloscope is in the analog mode, and is disabled when the oscilloscope operates in the digital storage mode. The circuit elements used for signal acquisition and display in the digital mode are controlled by fixed-frequency oscillators which do not permit continuous adjustment.

There has, however, been marketed a dual mode oscilloscope in which continuous adjustment of the timebase is provided both in the analog and digital modes (Publication TEK 2230/2220 of Tektronix GmbH, Sedanstr. 13-17, Köln, Germany). In the analog mode, the continuous-adjustment control alters the sweep rate, as mentioned above. In the digital storage mode, the sweep generator is not used for controlling the display, which is instead controlled by separate digital circuitry for accessing the stored data at a fixed rate and sending display signals in response thereto to the display screen. Continuous adjustment of the timebase is achieved by digitising the output of the sweep generator, and using the thus-generated digital signal to control the acquisition of samples from the input waveform. Thus, as the sweep rate increases due to operation of the continuous-adjustment control, the signal samples are taken at a higher rate, so that the stored samples which are then displayed on the screen represent a smaller portion of the input waveform.

There are a number of problems with this arrangement. First, the digital storage mode cannot provide any greater accuracy than the analog mode, because the signal acquisition circuits are driven by the analog sweep signal. Second, the devices needed to digitise the sweep signal increase the cost of the oscilloscope. Third, the "pre-trigger" mode cannot be used in such an oscilloscope. For this to be achieved, the sweep would have to start at such a time that the trigger point occurred at a predetermined point thereafter, e.g. approximately midway along the sweep ramp. Otherwise, some of the samples of interest will occur between the end of one sweep and the beginning of the next, when signal acquisition cannot occur. Because the trigger point cannot be predicted in advance, the oscilloscope cannot operate in this mode.

The present invention, which aims to overcome or at least mitigate some of these problems, provides a digital storage oscilloscope having a memory for storing successive samples of an input waveform and means for displaying the stored samples, the oscilloscope having a mode of operation in which a fixed-frequency oscillator controls the acquisition rate at which the samples are stored, and the oscilloscope being characterised in that it has a further mode of operation in which the acquisition rate at which the samples are stored is controlled instead by a variable oscillator whose frequency is continuously alterable by user-operable means.

It is envisaged that the digital storage oscilloscope would normally operate in the conventional manner, and provide the conventional advantages, e.g. high accuracy. The user would however have the ability to continuously adjust the timebase. If the user selected to adjust the timebase, the fixed-frequency oscillator would be disabled, and the variable oscillator switched into effect to control the timebase. The high accuracy of the oscilloscope would only be lost during the period that the user chose to use the continuous-adjustment feature. The oscilloscope would preferably have a pre-trigger mode, and this would remain operative even while the timebase is continuously adjusted. The user could thus display a waveform portion on the screen, with the trigger point in the centre, and by operating the continuous-adjustment control could expand or contract the portions of the waveform on each side of the trigger point.

The preferred embodiment of the invention is a dual mode oscilloscope, which can operate alternatively as an analog oscilloscope. Preferably, a single control is used for continuous adjustment of the timebase both in the analog mode and the digital storage mode. The control may for example be a potentiometer. Means responsive to operation of the potentiometer are used to select either the fixed-frequency oscillator or the variable oscillator for controlling the timebase in the digital storage mode. Such means could take the form of a switch ganged to the potentiometer, or a sensor responsive to changes of voltage as a result of adjustment of the potentiometer.

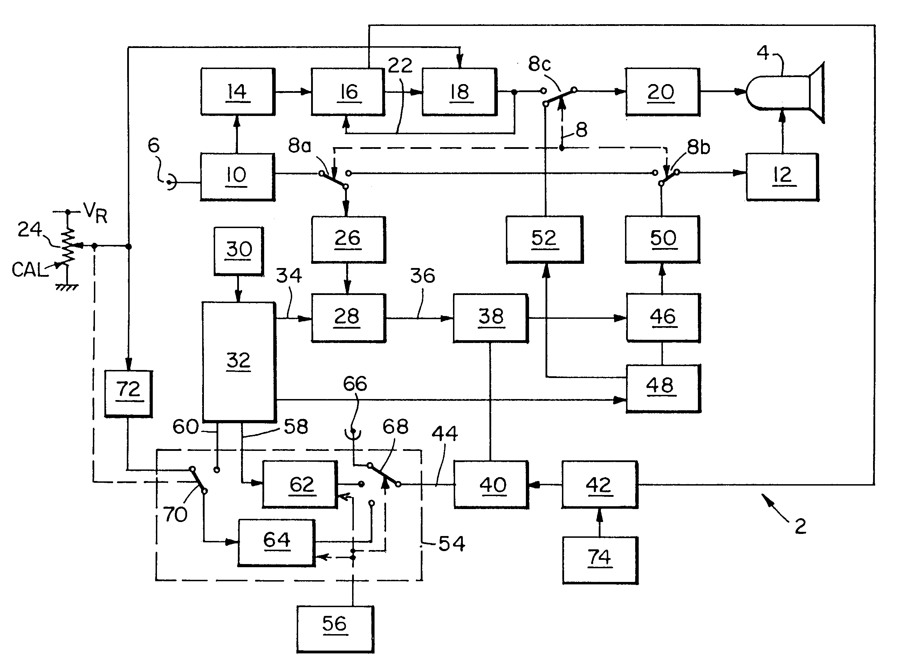

An arrangement embodying the invention will now be described by way of example with reference to the accompanying drawing, the single figure, Figure 1, of which shows in functional block diagram form a dual mode oscilloscope according to the invention.

The oscilloscope 2 has a CRT 4 for displaying selected portions of an input waveform appearing at input terminal 6. The oscilloscope has an analog/digital storage mode selection switch 8, comprising sections 8a, 8b, and 8c, which enable selection between the analog mode and the digital storage mode of the oscilloscope. In the accompanying figure, the switch 8 is shown in the position in which the digital storage mode is selected.

Assuming that the switch 8 is shifted to its opposite position, to select the analog mode, then an input processing circuit 10, comprising attenuators and vertical pre-amplifiers, will process the input waveform appearing at terminal 6, and deliver an output to a vertical output drive circuit 12, which in response thereto controls the voltages on the Y-plates of the CRT, and therefore the vertical deflection of the electron beam. The input processing circuit 10 also has an output which is applied to a trigger circuit 14, which produces an output trigger pulse whenever a selected trigger point on the waveform is detected. The trigger pulse is delivered to a sweep logic circuit 16 which passes selected trigger pulses to a sweep generator 18. Each received trigger pulse causes the sweep generator 18 to produce at its output a rising voltage which is applied through a horizontal amplifier 20 to the X-plates of the CRT 4. After the output voltage of the sweep generator 18 reaches a predetermined level, it then drops to its initial level until a further trigger pulse is received by the sweep generator 18. A signal path 22 indicates to the sweep logic circuit 16 that the sweep ramp has terminated, whereupon a subsequent trigger pulse is permitted to pass to the sweep generator 18.

The speed at which the output voltage of the sweep generator 18 rises is controlled by a user-operable means 24 in the form of a potentiometer. By operating the potentiometer, the user can cause the wiper to adopt any selected voltage between ground and a reference voltage V_{R}. The potentiometer is provided in a known manner with a calibration setting CAL, e.g. at the position where the wiper adopts the ground potential.

When the switch 8 is set to the digital storage mode position, the signals from the input processing circuit 10 are delivered via a vertical interface circuit 26 to an analog-to-digital converter 28.

A crystal oscillator 30 provides very high frequency pulses to a clock divider 32. This divides the input frequency so as to provide outputs at a number of selected frequencies. One such output, e.g. at a frequency of 16 MHz, is provided on line 34 as a sampling pulse for the analog-to-digital converter 28. Thus, digitised samples of the input waveform appear on the output line 36 of the converter 28 at a very high rate. These samples are read into an acquisition memory 38. The memory addresses into which successive samples are read are generated by an acquisition counter 40 under the control of an acquisition control 42. The acquisition control 42 responds to a signal from the sweep logic circuit 16 to cause enabling of the acquisition counter 40. Acquisition counter 40 then counts up in response to a write clock appearing on line 44. It will be understood that the frequency of the write clock determines the speed at which the acquisition counter alters the addresses applied to the acquisition memory 38, and this in turn determines the duration of the input waveform represented by the samples stored in the acquisition memory 38.

The contents of the acquisition memory 38 are transferred to a display memory 46. This is addressed by a display counter 48 which operates at a fixed frequency derived from the clock divider 32. The contents of the display memory 46 are read out at a fixed rate, converted into an analog signal by a digital-to-analog converter 50, and then applied to the vertical output drive circuit 12. The display counter 48 also provides a signal to a storage ramp generator 52, which provides a sweep signal which may be of fixed frequency and slope. This is applied to the horizontal amplifier 20 to drive the X-plates in conjunction with the display signals derived from the memory 46.

The frequency of the write clock appearing on line 44, and hence the timebase setting of the oscilloscope in the digital storage mode, is controlled by a timebase circuit 54. This in turn is controlled by a user-operable timebase control 56. The timebase circuit 54 receives on lines 58 and 60 clock pulses from the clock divider 32, for delivery to controllable dividers 62 and 64, respectively. The timebase control 56 can select the division ratios of the dividers 62 and 64, and can determine whether the write clock on line 44 is derived from an external clock input 66, the divider 62 or the divider 64, using a switch 68. The pulses appearing on line 58 are at a high frequency, e.g. 16 MHz, and divider 62 is selected for fast sweep rates. The pulses 60 are at a lower frequency, e.g. 8 MHz, and divider 64 is selected for slower sweep rates. It will be understood that the control 56 permits stepwise adjustment of the acquisition rate, and thus of the timebase of the oscilloscope. The control 56 may also be used to switch components in the sweep generator 18 into and out of circuit in the analog mode, so as to provide stepwise variation of the sweep rate in this mode.

The output line 60 carrying the 8 MHz pulses is selectively coupled to the controllable divider 64 via a switch 70 ganged to the potentiometer 24. This connection is achieved only when the wiper of the potentiometer is in the calibration position. When the wiper is moved away from the calibration position, the switch 70 instead adopts the state shown in the accompanying figure, in which the output of a voltage controlled oscillator 72 is coupled instead to the input of the divider 64. The wiper of the potentiometer 24 is coupled to a control input of the voltage controlled oscillator 72, which is arranged so that as the voltage alters the frequency of the oscillator falls from a frequency of approximately 8 MHz when the potentiometer is in the calibration position.

Assuming that the potentiometer 24 is in its calibration position and that the control 56 has selected the output of the divider 64 for providing the write pulses, then the oscilloscope will operate in its normal, highly-accurate digital storage mode with the signal acquisition rate dependant upon the accurate 8 MHz pulses on line 60, which are derived from the crystal oscillator 30. As soon as the potentiometer 24 is shifted away from its calibration position, the output line 60 is disabled and the voltage controlled oscillator 72 generates the pulses from which the write clock 44 is derived. Further adjustment of the potentiometer 24 continuously adjusts the acquisition rate and hence the timebase of the display.

Instead of providing the switch 70 ganged to the potentiometer 24, a voltage sensor can be coupled to the wiper of the potentiometer 24, so as to provide a switching signal in response to a change in the voltage appearing thereon, the switching signal being used to switch the voltage controlled oscillator 72 into circuit in place of the output line 60.

A user-operable pre-trigger mode selection switch 74 can select a pre-trigger mode in which the acquisition control 42 causes continuous operation of the acquisition counter 40 until a predetermined number of samples have been taken following the occurrence of a trigger point. Assuming that the number of samples written-into the acquisition memory 38 exceeds its capacity, then the earliest samples are sequentially overwritten. The acquisition memory 38 will thus ultimately store samples taken both before and after the trigger point, so that the waveform displayed on the screen has the trigger point at an intermediate position, e.g. in the middle. It will be understood that continuous adjustment using the potentiometer 24 will not alter the position of the trigger point on the display, but will cause expansion of the displayed waveform on each side of the trigger point.

In this embodiment, the calibration position of the potentiometer is at one end of the wiper range, and continuous adjustment results only in a decrease in the sample acquisition rate. However, it would be possible instead for the continuous adjustment to increase, or selectively either increase or decrease, the sample acquisition rate.

Preferably, the effect on the timebase of any adjustment of the potentiometer 24 is substantially the same in the analog mode as in the digital mode. In this way, switching between analog and digital modes while the potentiometer is not in its calibration position will have little effect on the overall appearance of the displayed waveform, in contrast to the situation in the usual dual mode oscilloscope, wherein switching to the digital mode disables the potentiometer so that the timebase of the displayed waveform alters.

In the embodiment the variable oscillator can be brought into effect in only the lower timebase ranges, but it would alternatively be possible to arrange for it to be capable of being brought into effect in all ranges.

## Claims

1. A digital storage oscilloscope (2) having memory means (38,46) for storing successive samples of an input waveform, and means (4) for displaying the stored samples, the oscilloscope having a mode of operation in which a fixed-frequency oscillator (30) controls the acquisition rate at which the samples are stored, characterised in that the oscilloscope has a further mode of operation in which the acquisition rate at which the samples are stored is controlled by a variable oscillator (72) whose frequency is continuously alterable by user-operable means (24).

2. An oscilloscope as claimed in claim 1, wherein the oscilloscope can be selectively operated in both said modes to display a portion of an input waveform preceding a selected trigger point.

3. An oscilloscope as claimed in claim 2, wherein the oscilloscope is capable of displaying portions of the input waveform preceding and following the selected trigger point.

4. An oscilloscope as claimed in any preceding claim, including means (70) responsive to operation of said user-operable means (24) for initiating said further mode of operation.

5. A dual mode analog/digital storage oscilloscope (2), the oscilloscope having a first mode of operation in which an input waveform is coupled via an analog signal path to deflection means for controlling the deflection of an electron beam on a screen (4) of the oscilloscope, the oscilloscope including user-operable means (24) for continuously adjusting the sweep rate of the oscilloscope during said first mode of operation, the oscilloscope also having a second mode of operation in which digitised samples of the input waveform are stored in memory means (38,46) and the contents of the memory means (38,46) are read out in order to control a display on said screen (4), the acquisition rate at which the digitised samples are stored being controlled in response to a fixed-frequency oscillator (30), characterised in that the oscilloscope has a third mode of operation in which the memory means (38,46) stores samples for display on the screen at an acquisition rate which is controlled by a variable frequency oscillator (72) which is brought into effect in place of the fixed-frequency oscillator (30) and the frequency of which is alterable by said user-operable means (24).

6. An oscilloscope as claimed in claim 5, wherein the oscilloscope can be selectively operated in said second and third modes to display a portion of an input waveform preceding a selected trigger point.

7. An oscilloscope as claimed in claim 6, wherein the oscilloscope is capable of displaying portions of the input waveform preceding and following the selected trigger point.

8. An oscilloscope as claimed in any one of claims 5 to 7, including means (70) responsive to operation of said user-operable means (24) for initiating said third mode of operation.

9. An oscilloscope as claimed in any one of claims 5 to 8, wherein the effect on the timebase of the displayed waveform caused by adjustment of said user-operable means (24) is substantially the same in said first mode as in said third mode.

## Patentansprüche

1. Digitales Speicheroszilloskop (2) mit einer Speichervorrichtung (38, 46) zum Speichern aufeinanderfolgender Abtastwerte einer Eingangswellenform und einer Vorrichtung (4) zum Anzeigen der gespeicherten Abtastwerte, wobei das Oszilloskop einen Betriebsmodus hat, in dem ein Oszillator (30) mit fester Frequenz die Erfassungsrate steuert, mit der die Abtastwerte gespeichert werden, dadurch gekennzeichnet, daß das Oszilloskop einen weiteren Betriebsmodus hat, in dem die Erfassungsrate, mit der die Abtastwerte gespeichert werden, durch einen variablen Oszillator (72) gesteuert wird, dessen Frequenz durch eine vom Benutzer betätigbare Vorrichtung (24) kontinuierlich veränderbar ist.

2. Oszilloskop nach Anspruch 1, worin das Oszilloskop selektiv in beiden Modi betreibbar ist, um einen Teil einer Eingangswellenform anzuzeigen, die einem ausgewählten Triggerpunkt vorausgeht.

3. Oszilloskop nach Anspruch 2, worin das Oszilloskop in der Lage ist, Teile der Eingangswellenform anzuzeigen, die vor und nach dem ausgewählten Triggerpunkt auftreten.

4. Oszilloskop nach einem der voranstehenden Ansprüche, mit einer Vorrichtung (70), die auf den Betrieb der vom Benutzer betätigbaren Vorrichtung (24) anspricht, um den weiteren Betriebsmodus auszulösen.

5. Analog/Digital-Speicheroszilloskop (2) mit dualem Modus, wobei das Oszilloskop einen ersten Betriebsmodus hat, in dem eine Eingangswellenform über einen analogen Signalweg mit einer Ablenkvorrichtung gekoppelt ist, um die Ablenkung eines Elektronenstrahles auf einem Bildschirm (4) des Oszilloskops zu steuern, wobei das Oszilloskop eine vom Benutzer betätigbare Vorrichtung (24) zur kontinuierlichen Einstellung der Sweeprate des Oszilloskops während des ersten Betriebsmodus aufweist und das Oszilloskop auch einen zweiten Betriebsmodus hat, in dem digitalizierte Abtastwerte der Eingangswellenform in einer Speichervorrichtung (38, 46) gespeichert werden und der Inhalt der Speichervorrichtung (38, 46) ausgelesen wird, um eine Anzeige auf dem Bildschirm (4) zu steuern, wobei die Erfassungsrate, mit der die digitalisierten Abtastwerte gespeichert werden, in Abhängigkeit von einem Festfrequenzoszillator (30) gesteuert wird, dadurch gekennzeichnet, daß das Oszilloskop einen dritten Betriebsmodus hat, in dem die Speichervorrichtung (38, 46) Abtastwerte zur Anzeige auf dem Bildschirm mit einer Abtastrate speichert, die durch einen Oszillator (72) mit variabler Frequenz gesteuert wird, der anstelle des Festfrequenzoszillators (30) zur Wirkung gebracht wird und dessen Frequenz durch die vom Benutzer betätigbare Vorrichtung (24) veränderbar ist.

6. Oszilloskop nach Anspruch 5, worin das Oszilloskop selektiv im zweiten und dritten Modus betreibbar ist, um einen Teil einer Eingangswellenform anzuzeigen, der vor einem ausgewählten Triggerpunkt auftritt.

7. Oszilloskop nach Anspruch 6, worin das Oszilloskop in der Lage ist, Teile der Eingangswellenform anzuzeigen, die vor und nach dem ausgewählten Triggerpunkt auftreten.

8. Oszilloskop nach einem der Ansprüche 5 bis 7, mit einer Vorrichtung (70), die auf den Betrieb der vom Benutzer betreibbaren Vorrichtung (24) anspricht, um den dritten Betriebsmodus auszulösen.

9. Oszilloskop nach einem der Ansprüche 5 bis 8, worin die Auswirkung auf die Zeitbasis der angezeigten Wellenform, wie sie durch die Einstellung der vom Benutzer betätigbaren Vorrichtung (24) hervorgerufen wird, im ersten und im dritten Modus im wesentlichen gleich ist.

## Revendications

1. Oscilloscope à mémoire numérique (2), comportant des moyens à mémoire (38,46) pour mémoriser des échantillons successifs d'une forme d'onde d'entrée et des moyens (4) pour afficher les échantillons mémorisés, l'oscilloscope ayant un mode de fonctionnement dans lequel un oscillateur à fréquence fixe (30) commande la vitesse de saisie à laquelle les échantillons sont mémorisés, caractérisé en ce que l'oscilloscope a un autre mode de fonctionnement dans lequel la vitesse de saisie à laquelle les échantillons sont mémorisés est commandée par un oscillateur variable (72) dont la fréquence peut être modifiée de façon continue par des moyens (24) actionnés par l'utilisateur.

2. Oscilloscope selon la revendication 1, dans lequel l'oscilloscope peut être mis en fonctionnement sélectivement dans lesdits deux modes pour afficher une partie d'une forme d'onde d'entrée précédant un point de déclenchement choisi.

3. Oscilloscope selon la revendication 2, dans lequel l'oscilloscope est capable d'afficher des parties de la forme d'onde d'entrée précédant et suivant le point de déclenchement choisi.

4. Oscilloscope selon l'une quelconque des revendications précédentes, comportant des moyens (70) sensibles au fonctionnement desdits moyens (24) actionnés par l'utilisateur pour déclencher ledit autre mode de fonctionnement.

5. Oscilloscope à mémoire numérique (2) à deux modes analogique/numérique, cet oscilloscope ayant un premier mode de fonctionnement dans lequel une forme d'onde d'entrée est liée par un trajet de signaux analogiques à des moyens déviateurs pour commander la déviation d'un faisceau cathodique sur un écran (4) de l'oscilloscope, l'oscilloscope comportant des moyens (24) actionnés par l'utilisateur pour régler de façon continue la vitesse de balayage de l'oscilloscope pendant ledit premier mode de fonctionnement, l'oscilloscope ayant aussi un deuxième mode de fonctionnement dans lequel des échantillons numérisés de la forme d'onde d'entrée sont mémorisés dans des moyens à mémoire (38,46), le contenu des moyens à mémoire (38,46) étant lu pour commander un affichage sur ledit écran (4), la vitesse de saisie à laquelle les échantillons numérisés sont mémorisés étant commandée sous l'action d'un oscillateur à fréquence fixe (30), caractérisé en ce que l'oscilloscope a un troisième mode de fonctionnement dans lequel les moyens à mémoire (38,46) mémorisent des échantillons, pour l'affichage sur l'écran, à une vitesse de saisie commandée par un oscillateur à fréquence variable (72) qui est mis en action à la place de l'oscillateur à fréquence fixe (30) et dont la fréquence peut être modifiée par lesdits moyens (24) actionnés par l'utilisateur .

6. Oscilloscope selon la revendication 5, dans lequel l'oscilloscope peut être mis en fonctionnement sélectivement dans lesdits deuxième et troisième modes pour afficher une partie de la forme d'onde d'entrée précédant un point de déclenchement choisi.

7. Oscilloscope selon la revendication 6, dans lequel l'oscilloscope est capable d'afficher des parties de la forme d'onde d'entrée précédant et suivant le point de déclenchement choisi.

8. Oscilloscope selon l'une quelconque des revendications 5 à 7, comportant des moyens (70) sensibles au fonctionnement desdits moyens (24) actionnés par l'utilisateur pour déclencher ledit troisième mode de fonctionnement.

9. Oscilloscope selon l'une quelconque des revendications 5 à 8, dans lequel l'effet sur la base de temps de la forme d'onde affichée provoqué par le réglage desdits moyens (24) actionnés par l'utilisateur est sensiblement le même dans ledit premier mode et dans ledit troisième mode.
